# EUROPEAN PATENT APPLICATION

(11) **EP 1 748 497 A2**
(43) Date of publication of application: **31.01.2007**
(21) Application number: 06014614.9
(22) Date of filing: 13.07.2006
(51) Int. Cl.: H01L 33/00, H01L 21/20

(54) **Silicon carbon germanium (SiCGe) substrate for a group III nitride-based device**

(30) Priority: 26.07.2005 US 189286
(71) Applicant: Avago Technologies ECBU IP (Singapore) Pte. Ltd., Singapore 768923 (SG)
(72) Inventor: Robbins, Virginia M., P.O.Box 7599 Loveland CO 80537-0599 (US)
(74) Representative: Schoppe, Fritz

(57) **Abstract**

A substrate (110) for a group III nitride-based electronic device comprises a layer (102) of silicon carbon and a layer (104) of silicon carbon germanium over the layer (102) of silicon carbon, the layer (102) of silicon carbon and the layer (104) of silicon carbon germanium forming a substrate (110) for a group III nitride-based device (106).

## Description

### Background

Silicon carbide (SiC) is used as a substrate for a variety of electronic and optical devices. Many electronic and optical devices are formed of layers composed of one or more group III elements and nitrogen, and are generally referred to as group III nitrides. One of the group III nitrides is gallium nitride. Devices typically formed using the gallium nitride material system include, for example, transistors and light emitting devices. The gallium nitride material system includes alloys formed using various combinations of aluminum, boron, gallium, and indium with nitrogen. This includes the various binary endpoints and ternary endpoints such as aluminum nitride (A1N), gallium nitride (GaN), gallium indium nitride (GaInN), etc. Silicon carbide is a desirable substrate material for devices formed using the gallium nitride material system because it is electrically conductive. However, while having a crystal structure similar to the crystal structure of materials formed using the gallium nitride material system, the lattice constant of silicon carbide is smaller than the lattice constant of materials formed using the gallium nitride material system. The lattice mismatch between silicon carbide and materials formed using the gallium nitride material system causes dislocation defects to form in the gallium nitride material when the gallium nitride material is grown thicker than a critical thickness. These dislocations degrade the performance and reliability of gallium nitride-based devices.

Unfortunately, substrates that exhibit suitable electrical characteristics and that have a lattice constant similar to the lattice constant of materials formed using the gallium nitride material system have not been developed. Therefore, the development of devices formed in the gallium nitride material system on a silicon carbide substrate has necessitated the development of elaborate growth schemes such as epitaxial lateral overgrowth, referred to as "ELOG," to reduce the defect density. Even after grown using a technique such as ELOG, the defect density in the gallium nitride grown on silicon carbide is still ~10⁶ /cm⁻². A substrate that is more closely lattice matched to materials formed using gallium nitride-based materials could allow the growth of gallium nitride-based materials with a lower dislocation density and improved device performance.

### Summary of the Invention

Embodiments in accordance with the invention provide a substrate for an electronic device formed in a group III nitride material system comprising a layer of silicon carbon and a layer of silicon carbon germanium over the layer of silicon carbon, the layer of silicon carbon and the layer of silicon carbon germanium forming a substrate for a device formed in the group III nitride material system.

Embodiments in accordance with the invention also comprise a method of forming a silicon carbon germanium substrate for an electronic device formed in a group III nitride material system. The method comprises forming a layer of silicon carbon, forming a layer of silicon carbon germanium over the layer of silicon carbon, and forming an electronic device in the group III nitride material system directly on the layer of silicon carbon germanium.

### Brief Description of the Drawings

The invention can be better understood with reference to the following drawings. The components in the drawings are not necessarily to scale, emphasis instead being placed upon clearly illustrating the principles of the present invention. Moreover, in the drawings, like reference numerals designate corresponding parts throughout the several views.

FIG. 1 is a schematic diagram illustrating an optoelectronic device formed over a silicon carbon germanium substrate in accordance with an embodiment of the invention.

FIG. 2 is a schematic diagram of an exemplary gallium nitride based laser formed on the substrate of FIG. 1.

FIG. 3 is a flow chart illustrating an exemplary method for forming a device over a substrate in accordance with the invention.

### Detailed Description

One way to decrease the lattice mismatch between the substrate and the gallium nitride-based materials is to add germanium to the silicon carbide substrate. Adding germanium to the silicon carbide substrate will increase the lattice constant of the substrate. The development of SiC:Ge alloys presents technological challenges and to date only small amounts of germanium have been incorporated into the silicon carbide crystal. X-ray diffraction data shows that the lattice constant of SiC:Ge is indeed increased compared to silicon carbide. Thin layers of SiC:Ge have been incorporated into an electronic device to form a silicon carbide heterostructure device. However, the use of germanium to form a substrate with a closer lattice-match to devices formed using a group III-nitride, and particularly the gallium nitride material system, has heretofore been unrealized.

Although the embodiments of the silicon carbon germanium substrate for a group III nitride-based device will be described in the context of forming a substrate for a gallium nitride-based device, other materials having a lattice constant similar to the lattice constant of the layers of a gallium nitride-based device can also be formed on the silicon carbon germanium substrate.

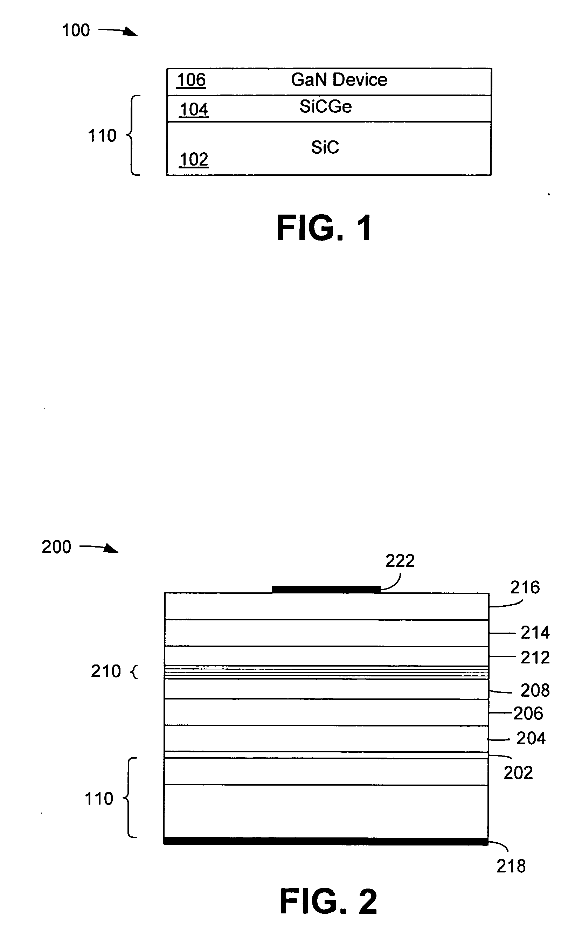

FIG. 1 is a schematic diagram illustrating an optoelectronic device formed over a silicon carbon germanium substrate in accordance with an embodiment of the invention. The optoelectronic device 100 can be, for example, a light emitting device such as a laser or a light emitting diode, or can be any other electronic device formed using the group III nitride, and in particular, the gallium nitride, material system. The electronic device 100 comprises a first substrate layer 102 composed of silicon and carbon. In one embodiment, the first substrate layer 102 is composed of silicon carbide (SiC). The first substrate layer 102 has an in-plane (a-axis) lattice constant of 3.086 angstroms (Å). A second substrate layer 104 of silicon carbon germanium is formed over the first substrate layer 102. In one embodiment, the second substrate layer 104 is silicon carbide germanium (SiC:Ge) having a composition of (Si_{0.5-*x*}C_{0.5*-y*})*Ge_{x+y},* where 0≤x≤0.5 and, 0≤*y*≤0.5.

In a particular embodiment, the composition of the second substrate layer 104 is (Si_{0.5-x}C_{0.5-*y*})Ge_{*x*+*y*}, where the germanium content varies from approximately 5% to approximately 40%. The values of x and y are chosen to provide the desired lattice constant for the subsequent device layers. In one embodiment, the second substrate layer 104 has a composition of Si_{0.35} C_{0.5}Ge_{0.15}. However, the second substrate layer 104 may have a composition that ranges between and includes Si_{0.45} C_{0.5}Ge_{0.05} and Si_{0.10} C_{0.5}Ge_{0.4}. Due to the bond lengths of silicon, carbon and germanium, it is likely that the germanium will substitute for the silicon, but a portion of the germanium may also substitute for carbon. If a gallium nitride device is to be subsequently grown on the second substrate layer 104, the second substrate layer 104 should be formed with a composition of (Si_{0.5-*x*}C_{0.5-*y*})Ge_{*x*+*y*} to yield an in-plane lattice constant of 3.19Å. If an aluminum nitride device is to be subsequently grown on the second substrate layer 104, the second substrate layer 104 should be formed with a composition of (Si_{0.5-*x*}C_{0.5*-y*})Ge*_{x+y}* to yield an in-plane lattice constant of 3.11Å.

The first substrate layer 102 and the second substrate layer 104 comprise a substrate 110. The second substrate layer 104 has a lattice constant that closely approximates the lattice constant of gallium nitride and other materials formed in the gallium nitride material system. In one embodiment, an optoelectronic device formed using the gallium nitride material system is formed over the substrate 110 and directly over the second substrate layer 104**.** This is illustrated as a gallium nitride device formed as layer 106 over the second substrate layer 104. A typical device will consist of a number of layers having varying compositions of boron, aluminum, gallium, indium and nitrogen. In this example, the layer 106 of gallium nitride has a lattice constant of 3.19 Å, which closely matches the lattice constant of the second substrate layer 104. The close lattice match between the materials of the layers 104 and 106 allows the gallium nitride material of layer 106 (and subsequent layers which are not shown) to be grown dislocation-free to a thickness that is thicker than if the gallium nitride layer 106 were grown directly on the silicon carbide layer 102. This allows a gallium nitride-based device having high optical quality to be formed over the substrate 110.

The thickness to which the layer 106 can be formed over the second substrate layer 104 before dislocations begin to appear is greater than the thickness to which it could be formed directly over the silicon carbide layer 102. In this manner, a gallium nitride-based device having high optical quality can be formed. The lattice mismatch between the second substrate layer 104 containing about 5%-to about 40% germanium is significantly lower than the lattice mismatch between the first substrate layer 102 and the gallium nitride material of layer 106. The close lattice match between the second substrate layer 104 and the gallium nitride material of layer 106 allows the material of layer 106 to be grown significantly thicker without dislocations forming than if the layer 106 were grown directly over the first substrate layer 102.

FIG. 2 is a schematic diagram of an exemplary gallium nitride-based laser structure formed on the substrate 110 of FIG. 1. A conductive buffer layer 202 is formed over the substrate 110. In one embodiment, the conductive buffer layer 202 can be formed of gallium nitride at a relatively low growth temperature. An n-type layer 204 of gallium nitride is formed over the buffer layer 202. In one embodiment, the gallium nitride layer 204 is approximately 1 micrometer (um) thick. An n-type cladding layer 206 is formed of aluminum gallium nitride over the gallium nitride layer 204. The cladding layer 206 is approximately 0.4 um thick and is formed using AlₓGa₁₋ₓN, where *x*=0.12. A waveguide layer 208 is formed over the cladding layer 206. The waveguide layer 208 is approximately 0.1 um thick and is formed using Al*ₓ*Ga_{1-*x*}N, where *x*=0.06. An active region 210 comprising alternating layers of indium gallium nitride quantum well layers and gallium nitride barrier layers is formed over the waveguide layer 208. The active region may contain one or more quantum wells, and in this example, includes 8 quantum wells.

A waveguide layer 212 is formed over the active region 210. The waveguide layer 212 is approximately 0.1um thick and is formed using AlₓGa_{1-*x*}N, where *x*=0.06. A p-type cladding layer 214 is formed of aluminum gallium nitride over the waveguide layer 212. The cladding layer 214 is approximately 0.4um thick and is formed using AlₓGa₁₋ₓN, where *x*=0.12. A p-type layer 216 of gallium nitride is formed over the cladding layer 214. In one embodiment, the gallium nitride layer 216 is approximately 0.1 um thick. An n-type contact 218 is formed on the substrate 110 and a p-type contact 222 is formed on the p-type layer 216 of gallium nitride.

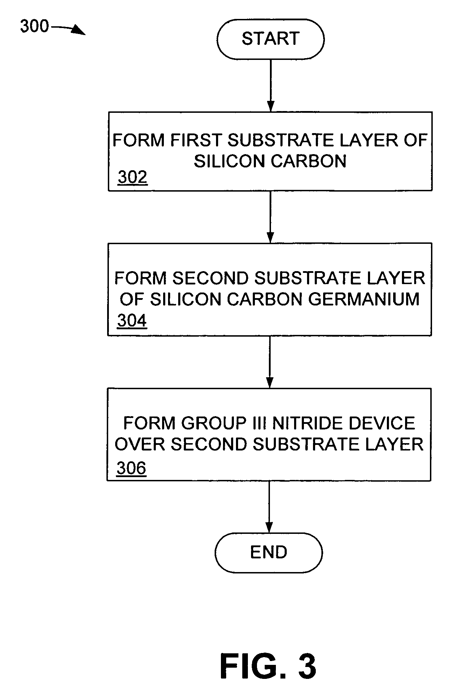

FIG. 3 is a flow chart illustrating an exemplary method for forming a device over a substrate in accordance with the invention. In block 302, a first substrate layer 102 of silicon carbon is formed. In an exemplary embodiment, the first substrate layer 102 is silicon carbide (SiC). In block 304, a second substrate layer 104 of silicon carbon germanium is formed. In an exemplary embodiment, the second substrate layer 104 is silicon carbide germanium (SiC:Ge) having a composition of (Si_{0.5-*x*}C _{0.5-*y*})Ge_{*x*+*y*}, where 0≤*x*≤0.5 and, 0≤*y*≤0.5 and a lattice constant of 3.19Å. The first substrate layer 102 and the second substrate layer 104 form a substrate 110. In block 306, a group III nitride, and in particular, a gallium nitride-based device is formed over the substrate 110, and in particular, is formed directly over the second substrate layer 104. The lattice constant of the layers of the gallium nitride-based device closely match the lattice constant of the SiC:Ge material of the second substrate layer 104. The lattice match between the SiC:Ge material of the second substrate layer 104 and the material of the gallium nitride-based device allows a high optical quality gallium nitride-based optoelectronic device to be formed on the substrate 110.

This disclosure describes the invention in detail using illustrative embodiments. However, it is to be understood that the invention defined by the appended claims is not limited to the precise embodiments described.

## Claims

1. A method (300) of forming a silicon carbon germanium substrate (110) for an electronic device formed in a group III nitride material system, comprising:
Forming (302) a layer of silicon carbon (102);
Forming (304) a layer of silicon carbon germanium (104) over the layer of silicon carbon (102); and
Forming (306) an electronic device (106) comprising a group III nitride directly on the layer of silicon carbon germanium (104).

2. The method (300) of claim 1, in which the silicon carbon germanium (104) has a composition of (Si_{0.5-x}C_{0.5-*y*})Ge_{*x*+*y*}, where 0≤*x*≤0.5 and, 0≤*y*≤0.5.

3. The method (300) of claim 2, in which the silicon carbon germanium (104) has a composition of Si_{0.35} C_{0.5}Ge_{0.15}.

4. The method (300) of claim 2, in which the silicon carbon germanium (104) layer is more closely lattice matched to gallium nitride than the silicon carbon is matched to gallium nitride.

5. The method (300) of claim 2, in which the silicon carbon germanium (104) layer is formed to have a lattice constant of 3.19 Angstroms (A).

6. A silicon carbon germanium substrate (110) for an electronic device formed in a group III nitride material system, comprising:
a layer (102) of silicon carbon;
a layer (104) of silicon carbon germanium over the layer (102) of silicon carbon, the layer (104) of silicon carbon germanium comprising (Si_{0.5-*x*}C_{0.5-*y*})Ge*_{x+y}*, where 0≤x≤0.5 and, 0≤y≤0.5; and
an electronic device (106) comprising gallium and nitrogen directly on the layer (104) of silicon carbon germanium.

7. The substrate (110) of claim 6, in which the silicon carbon germanium has a composition between and including Si_{0.45}C_{0.5}Ge_{0.05} and Si_{0.10}C_{0.5}Ge_{0.4}.

8. The substrate (110) of claim 7, in which the silicon carbon germanium layer (104) is more closely lattice matched to gallium nitride than the silicon carbon is lattice matched to gallium nitride.

9. The substrate (110) of claim 6, in which the silicon carbon germanium layer (104) is formed to have a lattice constant of 3.19 Angstroms (Å).

10. The substrate (110) of claim 6, in which the silicon carbon germanium layer (104) is formed to have a lattice constant of 3.11 Angstroms (Å).
